# EUROPEAN PATENT APPLICATION

(11) **EP 2 481 844 A2**
(43) Date of publication of application: **01.08.2012**
(21) Application number: 12150533.3
(22) Date of filing: 10.01.2012
(51) Int. Cl.: D06F 33/02

(54) **Washing machine and method of controlling the same**

(30) Priority: 31.01.2011 KR 20110009827
(71) Applicant: Samsung Electronics Co., Ltd., Suwon-si, Gyeonggi-do 443-742 (KR)
(72) Inventor: Kim, Hyun Sook, Gyeonggi-do (KR); Bang, Eun Suk, Gyeonggi-do (KR)
(74) Representative: Grünecker, Kinkeldey, Stockmair & Schwanhäusser

(57) **Abstract**

A washing machine (400) and a method of controlling the same include a motor (412) to rotate a rotary tub (411) including laundry, a heater (430) to heat water contained in the rotary tub (411), a communication unit (441) to receive an energy saving signal having information regarding an energy saving start time from an energy management system (EMS) (300), and a controller (442), upon receiving the energy saving signal, to determine which one of the motor (412) and the heater (430) is a load having highest power consumption in a process to be executed at the energy saving start time, and reduce the operation rate of the determined load. Before current power rates exceed reference power rates, the load operation rate of the washing machine (400) is changed so that power consumption is greatly reduced.

## Description

### BACKGROUND

### 1. Field

Embodiments relate to a washing machine to adjust/control load driving to achieve power saving.

### 2. Description of the Related Art

With the development of Information Technology (IT), the number of household appliances powered by electricity is rapidly increasing, in turn leading to increasing power demand and consumption. In order to satisfy such increased power demand, the number of power plants is rapidly increasing. However, as can be seen from a power demand pattern, peak capacity is not reached during most days of the year. More specifically, power plants only operate at full capacity during a few days out of the year.

A state in which a high power demand is required for a short time is called peak load. Construction costs for adding an additional power plant to the power grid are extremely high and maintenance costs for power plants constructed to maintain peak load for a short period are considerable.

Recently, numerous developers have conducted intensive research into a demand management method for temporarily restricting power consumption by limiting peak load without constructing such additional power plants. For the aforementioned purposes, demand management is a focus of attention, and a great deal of research is focused upon an advanced demand management format for demand response (DR).

DR is a system for intelligently managing energy consumption depending upon variation in power rates. For example, the consumer may temporarily stop an air-conditioner so as to reduce power consumption when power rates are high.

By the DR system, a power-supply source can alter end user power consumption to achieve load balancing and can restrict end user power consumption to periods when demand is low, thereby reducing the user's overall energy expenditure.

Therefore, a smart electric device to which demand response (DR) is applied has been developed, and an energy management system (EMS) of controlling the driving of the smart electric device has been developed. That is, the EMS informs the user of power rate information, and is turned on or off in response to the power rate information.

Accordingly, it is impossible to obtain the result at a user desired time.

Specifically, the washing machine operates a heater to perform a heated washing function at a predetermined temperature, or uses hot water provided from an external part to wash laundry. The washing machine uses high instantaneous power due to the use of the heater. If the washing machine uses the heater for a long period of time, the washing machine unavoidably consumes a large amount of electricity. That is, if power rates are high, it is very important to control the driving of the washing machine.

Upon receiving power rate information from the power supply source, the washing machine is turned on or off on the basis of the received power rate information.

As a result, the washing machine stops operation during a time period of high power rates and is driven during a time period of low power rates. In this case, electricity bills can be reduced, but it is impossible for a user to obtain a desired washing performance at a desired time.

In addition, when the washing machine is driven in the time period of high power rates, the operation states of all constituent elements are simultaneously deteriorated and the washing machine performs a washing operation, it is difficult to satisfy a user-desired washing degree.

### SUMMARY

Therefore, it is an aspect of the present embodiments to provide a washing machine and a method of controlling the same, which change a washing cycle before power rate information is identical to or higher than reference power rate information under the condition that the power rate information is higher than the reference power rate information.

It is another aspect of the present embodiments to provide a washing machine to adjust an operation rate of load in response to the increasing power rates when a washing cycle is changed, and a method of controlling the same.

It is another aspect of the present embodiments to provide a washing machine to adjust an operation rate of the highest-power-consumption load when a washing cycle is changed, and a method of controlling the same.

Additional aspects will be set forth in part in the description which follows and, in part, will be apparent from the description, or may be learned by practice of the invention.

In accordance with one aspect of the present embodiments, a washing machine includes a motor to rotate a rotary tub including laundry, a heater to heat water contained in the rotary tub, a communication unit to receive power rate information for each hour from an energy management system (EMS), and a controller to recognize current power rates from among the received power rate information for each hour, determine if the current power rates exceed a reference power rates by comparing the current power rates with the reference power rates, and reduce an operation rate of any one of the motor and the heater if the current power rates exceed the reference power rates.

The washing machine may further include a storage unit to store power consumption of the motor and power consumption of the heater, wherein the controller recognizes a current washing section from among several washing sections, recognizes one load having highest power consumption from among several loads operated in the current washing section, and reduces an operation rate of the recognized load.

The washing machine may further include a storage unit to store an operation rate corresponding to power rates, wherein the controller recognizes a current washing section from among several washing sections, recognize one load having highest power consumption from among several loads operated in the current washing section, and reduces an operation rate of the recognize load to a specific operation rate corresponding to the current power rates.

The controller may divide each of a washing process and a rinsing process from among the washing sections into a heating section and a non-heating section, determine which load has highest power consumption from among several loads operated in each divided section, and control the determined load to be operated at an operation rate corresponding to the current power rates.

The washing machine may further include a storage unit to store a dehydration speed corresponding to power rates, wherein the controller reduces a dehydration speed of a dehydration process section from among the washing sections to a specific dehydration speed corresponding to the current power rates.

The controller determines whether power rates are changed in the washing and rinsing processes on the basis of the power rate information for each hour, recognizes the next power rates when the power rates are changed in the washing and rinsing processes, determines whether the next power rates are higher than the reference power rates by comparing the next power rates with the reference power rates, and reduces the operation rate of either the motor or the heater from a power-rate change time when the next power rates are higher than the reference power rates.

The controller may adjust the operation rate of either the motor or the heater from a specific time earlier than the power-rate change time by a predetermined time.

The controller may determine whether power rates are changed in a dehydration process on the basis of the power rate information for each hour, recognize the next power rates when the power rates are changed in the dehydration process, determine whether the next power rates are higher than the reference power rates by comparing the next power rates with the reference power rates, and reduce the operation rate of either the motor or the heater from a power-rate change time when the next power rates are higher than the reference power rates.

The washing machine may further include the input unit to receive a power saving rate from a user, wherein the controller adjusts the operation rate of either the motor or the heater in response to the power saving rate.

The washing machine may further include a storage unit to store load operation rates for each process at a point less than the reference power rates, wherein the controller controls the operation rates of the motor and the heater on the basis of the operation rate stored in the storage unit when the current power rates are less than the reference power rates.

In accordance with another aspect of the present embodiments, a method of controlling a washing machine that includes a motor to rotate a rotary tub including laundry and at least one heater to heat water contained in the rotary tub includes receiving power rate information for each hour from an energy management system (EMS), recognizing current power rates on the basis of the power rate information for each hour, determining whether the current power rates are higher than reference power rates by comparing the current power rates with the reference power rates, and reducing an operation rate of any one of the motor and the at least one heater when the current power rates are higher than the reference power rates.

The reducing of the operation rate of any one of the motor and the at least one heater may include recognizing a washing section, recognizing a load to be operated in the recognized washing section, recognizing each load having highest power consumption from among several loads to be operated in the recognized washing section, and reducing the operation rate of each load having the highest power consumption in the recognized washing section.

The reducing of the operation rate of any one of the motor and the at least one heater may include reducing the operation rate of each load having the highest power consumption to an operation rate corresponding to the current power rates.

The method may further include controlling operation rates of the motor and the at least one heater on the basis of a predetermined operation rate when the current power rates are equal to or less than the reference power rates.

The method may further include recognizing an execution time of the washing process, determining whether power rates are changed in the washing process execution time on the basis of power rate information for each hour, if the power rates are changed in the washing process execution time, recognizing the next power rates and a power-rate change time, and comparing the next power rates with reference power rates to determine whether the next power rates are higher than the reference power rates, and reducing an operation rate of the motor and at least one heater from the power-rate change time when the next power rates are higher than the reference power rates.

The reducing the operation rate of any one of the motor and the heater may include recognizing a washing section to be activated at the power-rate change time, recognizing a load having highest power consumption from among several loads operated in the recognized washing section, and adjusting an operation rate of the recognized load.

The method may further include, if the next power rates are equal to or less than the reference power rates, allowing each of the motor and the at least one heater to be operated at a predetermined operation rate from the power-rate change time.

The reducing the operation rate of any one of the motor and the heater may include adjusting the operation rate of any one of the motor and the at least one heater from a specific time earlier than the power-rate change time by a predetermined time.

In accordance with another aspect of the present embodiments, a washing machine includes a motor to rotate a rotary tub including laundry, a heater to heat water contained in the rotary tub, a communication unit to receive an energy saving signal having information regarding an energy saving start time from an energy management system (EMS), and a controller, upon receiving the energy saving signal, to determine which one of the motor and the heater is a load having highest power consumption in a process to be executed at the energy saving start time, and reduce the operation rate of the determined load.

The process may include a heating section and a non-heating section of each of washing and rinsing processes. The controller may determine the heater to be the load having the highest power consumption in the heating section, and determine the motor to be load having the highest power consumption in the non-heating section.

The process may include a dehydration process, and the controller may reduce a dehydration speed in the dehydration process.

In accordance with another aspect of the present embodiments, a method of controlling a washing machine that includes a motor to rotate a rotary tub including laundry and a heater to heat water contained in the rotary tub includes receiving an energy saving signal having information regarding an energy saving start time from an energy management system (EMS), upon receiving the energy saving signal, determining which one of the motor and the heater is a load having highest power consumption in a process to be executed at the energy saving start time, and reducing the operation rate of the determined load.

In accordance with another aspect of the present embodiments, a method of controlling a washing machine having a heating washing function includes receiving state information of a water heater supplying hot water to the washing machine from an energy management system (EMS), determining whether the water heater is turned off in response to the received water heater state information, and if the water heater is turned off, delaying an operation start of the washing machine until reaching a specific time at which the water heater starts operation, limiting a user-selectable water temperature on the basis of a current cold water temperature, and increasing either an operation rate of a motor or a washing time instead of reducing a water temperature.

### BRIEF DESCRIPTION OF THE DRAWINGS

These and/or other aspects of the invention will become apparent and more readily appreciated from the following description of the embodiments, taken in conjunction with the accompanying drawings of which:
FIG. 1 is a block diagram illustrating a power management system to which a washing machine is applied according to an embodiment;
FIG. 2 is a perspective view illustrating a washing machine according to one embodiment;
FIG. 3 is a cross-sectional view illustrating a washing machine according to one embodiment;
FIG. 4 is a block diagram illustrating a washing machine according to one embodiment;
FIG. 5 is a flowchart illustrating a method of controlling a washing machine according to one embodiment;
FIGS. 6 to 8 exemplarily illustrate a method of controlling a washing machine according to one embodiment;
FIG. 9 is a block diagram illustrating a power management system to which a washing machine is applied according to an embodiment;
FIG. 10 is a flowchart illustrating a method of controlling a washing machine according to another embodiment;
FIG. 11 is a flowchart illustrating a method for delaying a washing cycle or limiting a selectable washing cycle when a water heater of a washing machine is turned off according to another embodiment; and
FIG. 12 is a flowchart illustrating a method for proposing a substitute washing cycle when a water heater is turned off according to another embodiment.

### DETAILED DESCRIPTION

Reference will now be made in detail to the embodiments, examples of which are illustrated in the accompanying drawings, wherein like reference numerals refer to like elements throughout.

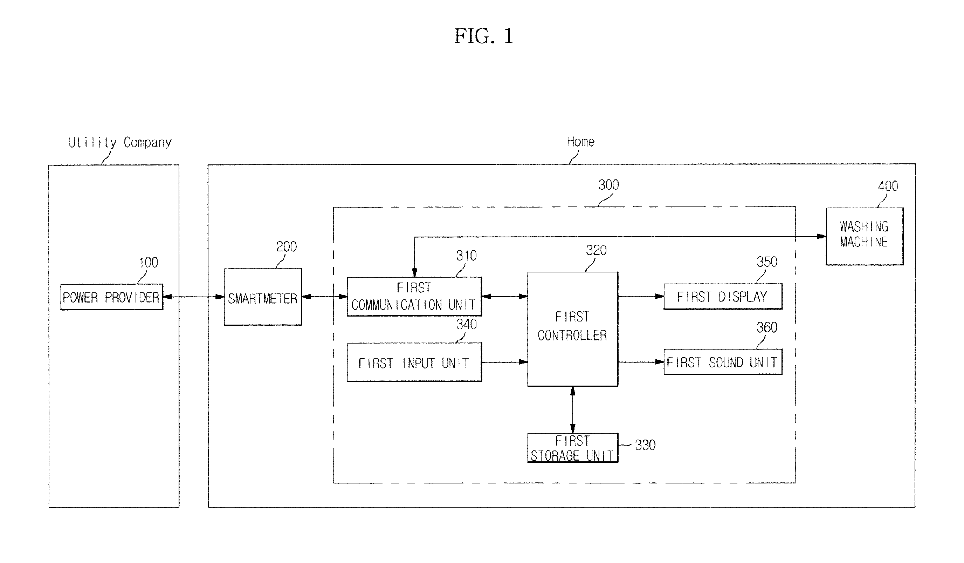

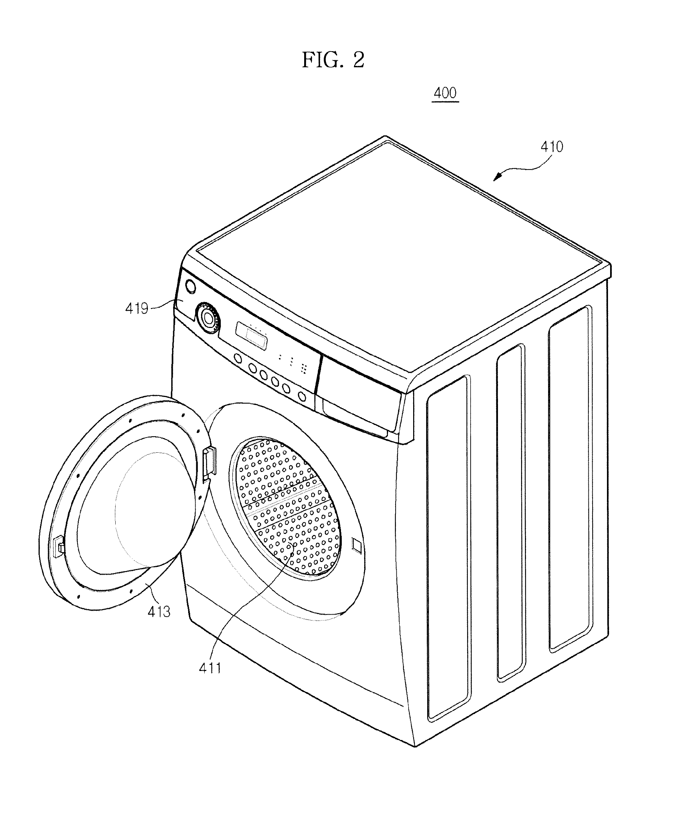

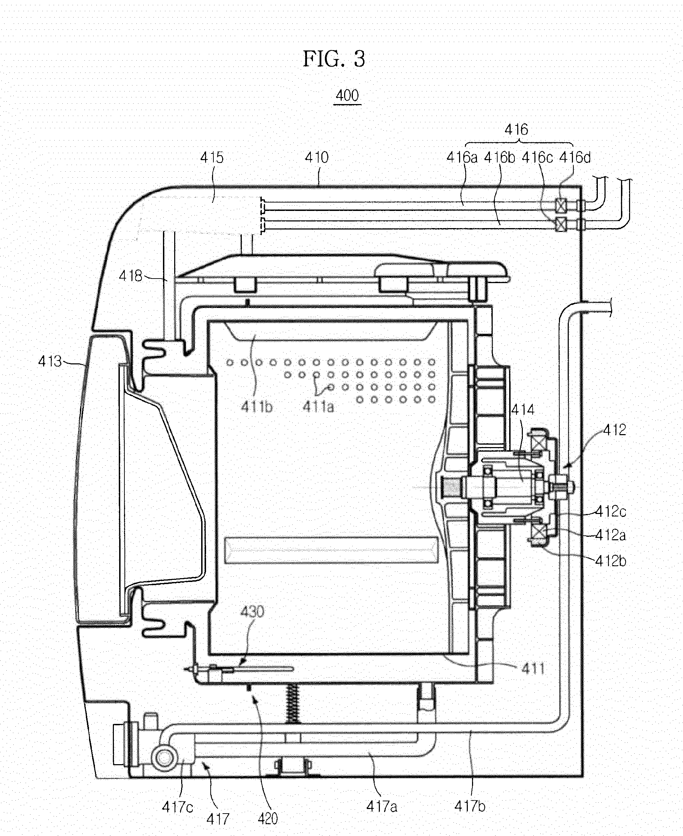

FIG. 1 is a block diagram illustrating a power management system to which a washing machine is applied according to an embodiment. FIG. 2 is a perspective view illustrating a washing machine according to one embodiment. FIG. 3 is a cross-sectional view illustrating a washing machine according to one embodiment;

A power management system including an energy management system (EMS) communicating with a washing machine will hereinafter be described with reference to FIG. 1.

Referring to FIG. 1, a power management system includes a power provider 100, a smart meter 200, an energy management system (EMS) 300, and a washing machine 400.

The power provider 100 is a power supply source that is operated by a power supply company (utility company) which generates and supplies power. The power provider 100 generates the power through atomic energy, hydroelectric power, geothermal power, wind power, etc., and provides the generated power to the washing machine 400 installed in homes.

The power provider 100 predicts power consumption on the basis of the generation amount of electric power, the past power consumption information for every season and every period, and weather information, and determines power rates on the basis of the predicted power consumption. In this case, it may also be possible to establish a power rate level corresponding to the predicted power rate as necessary.

The power provider 100 controls power rates of each home to be elastically adjusted in response to power consumption of each home, and provides the adjusted power to each home, such that demand can be balanced.

The power provider 100 collects power consumption amounts of individual homes classified according to individual power rates, and stores the collected power consumption information according to individual power rates, such that the power-supply company calculates power rates (electricity bills) depending upon power consumption for individual power rate levels of each home per month, and charges each home the calculated electricity bills on a monthly basis.

The power provider 100 compares the periodically calculated monthly power rate (monthly bills) with monthly predetermined power rates so as to calculate power bills. If the calculated monthly power rates exceed the monthly predetermined power rates, information about the excess of the monthly predetermined power rates is transmitted to the EMS 300 installed in the corresponding home, such that an event indicating the excess of monthly predetermined power rates is generated through the EMS 300 installed in each home.

The power provider 100 stores a threshold power amount for each home, compares power consumption amounts for each home with a threshold power amount, and thus decides a power limitation amount. In this way, the power provider 100 manages the power demand of each home on the basis of the threshold power amount or the monthly predetermined power rates.

The power provider 100 is connected to the smart meter 200 installed in each home, the EMS 300, and the washing machine 400 over a network, such that data regarding power demand management can be transmitted and received over the network. This network may be any of a wired network, a wireless network, a wired/wireless hybrid network, etc.

The smart meter 200 is installed in each home, and includes a display such as a liquid crystal display (LCD), such that power consumed in each home is displayed in real time. The smart meter 200 is an electronic meter, which bidirectionally communicates with the power provider 100 and transmits the consumed power amount to the power provider 100 and the EMS 300.

The smart meter 200 receives power rate information from the power provider 100, displays the received power rate information, and transmits the power rate information to the energy management system (EMS) 300.

In addition, the smart meter 200 may further display a price level corresponding to the power rate information upon receiving the power rate information from the power provider 100, and may also transmit the power rate and price level information to the EMS 300.

The EMS 300 may also be referred to as a Demand Response (DR) controller. The energy management system (EMS) 300 communicates with the smart meter 200, and thus receives power rate information and power rate level information from the smart meter 200.

The EMS 300 communicates with the washing machine 400 such thatthe EMS 300 receives power consumption information regarding the washing machine. In addition, the EMS 300 transmits power data to the washing machine 400, and controls the operation of the washing machine 400 on the basis of power consumption of the washing machine 400 and power rate level of the power provider 100.

The EMS 300 may also establish a power rate level on the basis of power rates upon receiving only the power rates from the power provider 100.

In this case, the EMS 300 receives power rate information of the power provider 100 through the smart meter 20 at intervals of a unit time, and establishes a power rate level for piece of each power rate information using the received power rate information for each unit time.

In this case, the number of the power rate levels may be 4 (DR1 to DR4), and a plurality of levels may have different power rates. Let us assume that the number of power rate levels is 4 (DR1 to DR4). In more detail, the power rate level DR1 is the lowest power rate level, and the power rate level DR4 is the highest power rate level. Power rate level is proportional to power rate.

The EMS 300 receives information about excess monthly threshold power and information about excess monthly predetermined power rates from the power provider 100, and informs the user of the received information.

When the EMS 300 compares the predicted (or current) power amount for each hour with the allowed instantaneous power amount, if the predicted (or current) power amount for each hour is equal to or greater than the allowed instantaneous power amount, operation of the washing machine 400 is controlled and the controlled result is output so as to inform the user of the controlled result.

Referring to FIG. 1, the EMS 300 includes a first communication unit 310, a first controller 320, a first storage unit 330, a first input unit 340, a first display 350, and a first sound unit 360.

The first communication unit 310 receives power rate information from the smart meter 200 and power rate level information corresponding to the received power rate information from the smart meter 200 by communicating with the smart meter 200, and transmits the received information to the first controller 320.

The first communication unit 310 receives operation information from the washing machine 400 by communicating with the washing machine 400, transmits the received information to the first controller 320, receives power rate information and an operation control signal of the washing machine 400 from the first controller 320, and transmits the received information to the washing machine 400.

In this case, the power rate information may be a previous day's officially fixed price received from the power provider 100 or may be a power rate that is received in real time from the power provider 100.

When transmitting power rate information to the washing machine 400, power rate information for each hour and power rate level information for each hour may be transmitted.

Upon receiving the previous day's officially fixed price, the first controller 320 confirms a time at which power rates are to be changed and a power rate value to be changed on the basis of the received previous day's officially fixed price.

In addition, if the first controller 320 receives power rate information in real time,the first controller 320 may predict a future power rate for each hour using a pre-stored past power consumption pattern, and confirm a time at which power rates are to be changed and a power rate level to be changed on the basis of the predicted future power rate for each hour.

The first controller 320 controls the first display 350 and the first sound unit 360, such thatthe first controller 320 informs the user of both a time at which power rates are to be changed and a power rate value to be changed, and transmits current power rates, a time at which the power rate is to be changed, and a power rate value to be changed to the washing machine 400.

In addition, the first controller 320 may calculate the operation rate of the washing machine 400 on the basis of current power rates, a time at which a power rate is changed, power rate data to be changed, and transmit the calculated operation rate to the washing machine 400.

In this case, the first controller 320 calculates the operation rate of one load having the highest power consumption from among several loads contained in the washing machine 400, and calculates the operation rate corresponding to the increase rate of the power rates in such a manner that power consumption can be reduced in direct proportion to the increase rate of the power rates.

The first storage unit 330 stores user information. In this case, the user information may include the monthly threshold power amount, the monthly predetermined power rate, the allowed power for each hour, and user personal information.

In addition, the first storage unit 330 may store power consumption of several loads contained in the washing machine 400, and may store the load operation rate corresponding to the increase rate of the power rate.

The first input unit 340 receives user information, and transmitsthe user information to the first controller 320.

The first input unit 340 may receive a selection signal to adjust the operation rate of the washing machine in response to variation of power rates.

In this case, if the user selects the selection signal to adjust the operation rate of the washing machine in response to variation of power rates, the first input unit 340 may transmit this selection signal to the first controller 320. Accordingly, the first controller 320 may control the operation rate of the washing machine when the power rate is changed according to the user selection signal.

In addition, the first controller 320 may transmit the selection signal to adjust the operation rate of the washing machine in response to the power rate variation received from the first input unit 340 to the washing machine 400.

The first input unit 340 may also receive the operation rate of the washing machine.

In this case, if the user inputs the operation rate of the washing machine, the first controller 320 controls the operation of the washing machine using the input operation rate of the washing machine. If total power consumption is close to the allowed power, it may also be possible to control the driving of other electric devices.

In addition, the first controller 320 may also transmit the washing machine operation rate received from the first input unit 340 to the washing machine 400.

The first display 350 may display either of the current power rates and the current power rate level, or may display either of the previous day's power rates for each hour and the previous days' power rate level.

The first display 350 displays not only a time at which power rates are to be changed, but also power rates to be changed.

The first display 350 displays the operation rate of the washing machine 400 while the washing machine 400 is driven, and displays operation rate adjustment information depending upon variation of the power rates.

The first input unit 340 and the first display 350 are integrated into one body, and may be configured in the form of a touchscreen.

The first sound unit 360 audibly outputs the operation rate information to be adjusted when the operation rate of the washing machine 400 is adjusted.

The first sound unit 360 audibly outputs a time at which the power rates are changed, and audibly outputs the power rates to be changed.

The first sound unit 360 audibly outputs information about the excess of the allowed power, information about the excess of the monthly threshold power, and information about the monthly predetermined electricity bills.

The washing machine 400 is connected to the EMS 300 by wire or wirelessly, receives either power rate information or an operation command transmitted from the EMS 300 by wire or wirelessly, is operated in response to the received power rate information or the operation command, and transmits, in real time, power consumption information for each operation mode to the EMS 300.

The structure of the washing machine 400 will hereinafter be described in detail.

FIG. 2 is a perspective view illustrating a washing machine according to one embodiment. FIG. 3 is a cross-sectional view illustrating a washing machine according to one embodiment;

Referring to FIGS. 2 and 3, the washing machine according to the embodiment includes a box-shaped main body 410 defining an outer appearance of the washing machine. A control panel 419, which includes a variety of buttons and a display panel to control the washing machine, is provided at an upper region of the front surface of the main body 410.

The washing machine includes a drum-shaped water tub 420 installed in the main body 410 to receive fresh water (wash water or rinse water) therein; a drum-shaped rotary tub 411 rotatably installed in the water tub 420 and having a plurality of holes 411 a formed through the remaining surfaces of the rotary tub 411; and drive motor to perform a washing operation, a rinsing operation, and a dehydration process by rotating the rotary tub 411.

The front part of the water tub 420 and the rotary tub 411 is opened in such a manner that laundry is put into or taken out of the rotary tub 411. A door 412 for opening or closing the opened front part of the water tub 420 and the rotary tub 411 is hinged to the front part of the main body 410.

A plurality of lifters 411 b for lifting laundry from a lower part to an upper part of the rotary tub 411 is arranged at an inner circumferential surface of the rotary tub 411 at intervals of a predetermined distance. The lifters 411 b enables laundry to move upward within the rotary tub 411 in response to rotation of the rotary tub 411, and enables the laundry located at a predetermined height to move downward in the rotary tub 411, so that the laundry can be washed.

A drive motor 412, acting as a driving device to rotate a rotation shaft 413 coupled to the rotary tub 411, is installed at the rear part of the water tub 420. The drive motor 412 includes a stator 412a fixed at the rear surface of the water tub 20, a rotator 412b rotatably installed at the outside of the stator 412a, and a rotator 412c for connecting the rotator 412b to the rotation axis 414.

A detergent supply unit 415 to supply detergent and a water supply unit 416 to supply water are installed above the water tub 420. A drain unit 417 to drain water from the water tub 420 is installed at the bottom of the water tub 420.

The detergent supply unit 415 has several partitioned spaces. The detergent supply unit 415 is mounted at the front side of the machine body 410 such that a user easily puts detergent and rinse in the partitioned spaces.

The water supply unit 416 includes water supply pipes 416a and 416b to supply wash water, and water supply valves 416c and 416d mounted on the water supply pipes 416a and 416b to control the supply of wash water through the water supply pipe 416a and 416b. The water supply pipes 416a and 416b are connected to the detergent supply unit 415 such that water can be supplied from the outside to the detergent supply unit 415.

The water supply pipe 416a or 416b includes a cold water pipe 416a to supply cold water from an external water supply device to the rotary tub 411, and a hot water pipe 416a to supply hot water from an external water supply device to the rotary tub 411. The water supply pipe 416a or 416b is coupled to the detergent supply unit 415 in such a manner that water received from an external part can be provided to the detergent supply unit 415. In addition, a separate connection pipe 418 is installed between the detergent supply unit 415 and the water tub 420 in such a manner that water passing through the detergent supply unit 415 is provided to the water tub 420.

The water supply valves 416c and 416d include a cold water valve 416d installed in the cold water supply pipe 416a and a hot water valve 416c installed in the hot water supply pipe 416b, respectively. The hot water valve 416c opens or closes the supply of hot water. Therefore, if the cold water valve 416d is turned on, cold water is supplied to the rotary tub 411 through the cold water supply pipe 416a. If the hot water valve 416c is turned on, hot water is supplied to the rotary tub 411 through the hot water supply pipe 416b.

A drain unit 417 includes a drain pump 417, a first drain pipe 417a, and a second drain pipe 417a. The drain pump 417 is mounted under the water tub 420 so as to drain water of the water tub 420 to the outside. The first drain pipe 417a is coupled to the water tub 420 through one end thereof, and is coupled to the drain pump 417 through the other end thereof. One end of the second drain pipe 417a is coupled to the drain pump 417, and the other end thereof is extended to the outside of the main body 410.

In accordance with the above-mentioned washing machine, in the case where a user opens the door 413, puts laundry into the rotary tub 411, and finally operates the washing machine, water mixed with detergent is supplied to the water tub 420 through the water supply pipe 416a and the detergent supply unit 415, laundry moves upward along the movement of the lifter 411 b by rotation of the rotary tub 411, and then moves downward, the laundry can be washed.

Meanwhile, in order to more effectively wash the laundry, a heater 430 for heating water is installed under the water tub 420.

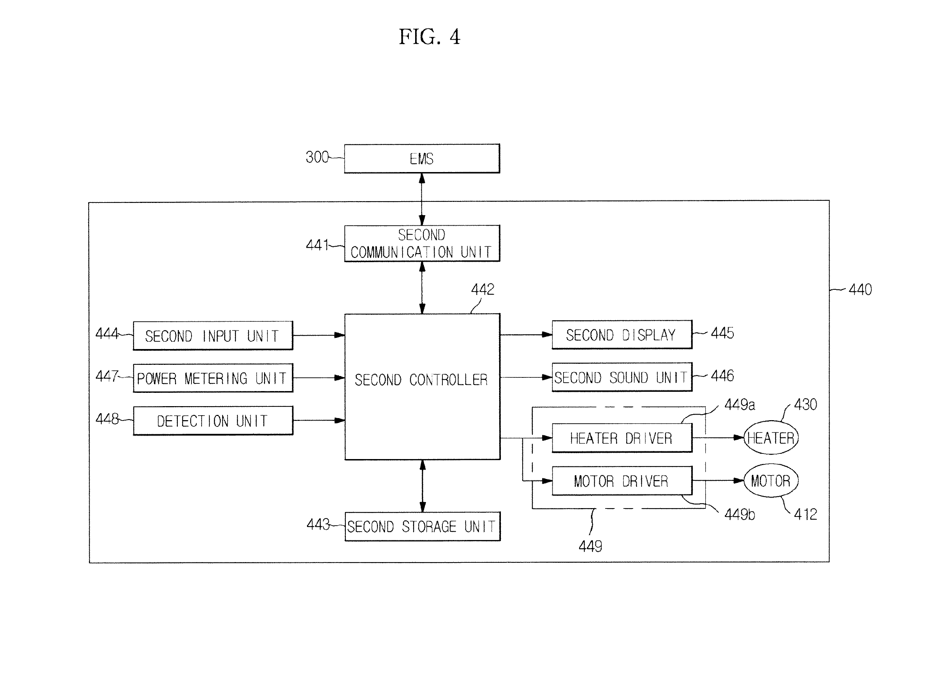

A control unit 440 for use in the above-mentioned washing machine will hereinafter be described with reference to FIG. 4.

FIG. 4 is a block diagram illustrating a washing machine according to one embodiment.

Referring to FIG. 4, the control unit 440 of the washing machine 400 includes a second communication unit 441, a second controller 442, a second storage unit 443, a second input unit 444, a second display 445, a second sound unit 446, a power measurement unit 447, a detection unit 448, and a load drive unit 449.

The second communication unit 441 communicates with the EMS 300, transmits operation information related to the washing process to the first communication unit 310 of the EMS 300 upon receiving a message from the second controller 442, and transmits an operation control signal received from the first communication unit 310 of the EMS 300 to the second controller 442.

The second communication unit 441 receives power rate information from the EMS 300. In this case, the power rate information includes at least one of power rates for each hour and a power rate level corresponding to power rates for each hour.

Upon receiving a command for starting the washing process, the second controller 442 determines current power rates on the basis of power rates for each hour, and compares the current power rates with reference power rates. If the current power rates are less than the reference power rates, the second controller 412 controls the operation rate of load with a predetermined operation rate. Otherwise, if the current power rates exceed the reference power rates, the second controller 412 determines the increasing rate of the current power rates on the basis of the reference power rates, and controls the operation of load with an operation rate corresponding to the determined increasing rate.

The second controller 442 confirms whether there arises a variation in power rates during the washing process. If the variation in power rates has occurred in the washing process, the second controller 412 recognizes the next power rate to be changed, and compares the next power rate with the reference power rate. If the next power rate is less than the reference power rate, the operation rate of the load is controlled at a predetermined operation rate. Otherwise, if the next power rate is higher than the reference power rate, the second controller 442 determines the increasing rate of the next power rate on the basis of the reference power rate, and controls the load operation with the operation rate corresponding to the determined increasing rate.

In this case, the price increasing rate based on the reference power rate may correspond to a reduction ratio of power to be reduced by the user, and this power saving rate may correspond to the operation rate of load to be adjusted by the washing machine.

The second controller 442 confirms at least one process in which the power rate is changed from among the washing, rinsing, and dehydration processes, and reduces the operation rate of the highest power consumption load within at least one confirmed process.

In this case, the second controller 442 confirms a variation time in which the power rate is changed, and reduces the operation rate of the highest power consumption load from a specific time located ahead of a predetermined time T on the basis of the variation time.

The second controller 442 determines whether the power rates are additionally changed. If the power rates are additionally changed, the second controller 442 confirms an additional change time, and controls the load operation rate in response to the comparison result between the current power rates and the reference power rates during the additional change time.

The second controller 442 sums the maximum instantaneous power amounts of other electric devices to be driven at an operation start time of the washing machine 400 on the basis of information stored in the first storage unit 330, such thatthe second controller 442 predicts power consumption to be generated while the washing machine 400 is driven. The second controller 442 compares the predicted power consumption with the allowed power amount, such thatthe second controller 442 may also control the operation rate of the washing machine when the predicted power consumption exceeds the allowed power amount. In this case, the second controller 412 adjusts and controls the load operation rate in response to the excess of power greater than the allowed power.

The second controller 442 divides an operation section of each of the washing process and the rinsing process into a heating section to heat wash water and a non-heating section not to heat wash water, and controls the operation rate of any one of several loads at every section. That is, the second controller 442 determines at least one load operated in each section of the washing and rinsing processes, and reduces the operation rate of the highest-power-consumption load from among the determined loads.

In this case, the heating section of the washing or rinsing process enables the heater 430 to be driven at the operation rate of 100% so as to heat wash water, and enables the motor 412 to be driven at the operation rate of 100% so as to perform the washing or rinsing operation.

In addition, the non-heating section of the washing or rinsing process enables the heater 430 to stop operation (i.e., the heater operation rate of 0%) in such a manner that wash water is not heated, and enables the motor 412 to be driven at the operation rate of 100% so as to perform the washing or rinsing operation.

The second controller 442 controls a motor speed at the dehydration process. That is, the second controller 442 reduces the motor speed in such a manner that a dehydration speed is reduced at the dehydration process.

If current power rates exceed reference power rates during the washing or rinsing process, the second controller 442 reduces the operation rate of the motor 412 to a predetermined operation rate, and reduces the operation rate of the heater 430 to a predetermined operation rate.

In more detail, the second controller 442 turns on or off the heater 430 of the highest power consumption at an energy rate that must be reduced by the washing machine prior to the rapid increasing of energy during the heating section of the washing or rinsing process. For example, if a target energy saving rate is set to the energy saving rate of 50%, until a current temperature reaches a predetermined temperature, the second controller 442 turns on the heater during 30 seconds and turns off the heater during 30 seconds, or turns on the heater during 1 minute and turns off the heater during 1 minute, such that the heater operation rate reaches 50%. In this case, the ratio of ON and OFF operations may be changed to that of an effective time at which a set temperature arrives and the washing/rinsing power is implemented.

In addition, the second controller 442 turns on or off the motor of the highest power consumption at an energy rate at which that must be reduced by the washing machine prior to the rapid increasing of energy during the non-heating section of the washing or rinsing process. For example, if a target energy saving rate is set to the energy saving rate of 50%, and the motor normal state of the washing or rinsing process is set to the order of 10-seconds ON → 5-seconds OFF, the second controller 442 turns on the motor for 5 seconds and turns off the motor for 10 seconds, or turns on the motor during 10 seconds and turns off the motor during 20 seconds, such that the motor operation rate is reduced from 66% to 33%.

In addition, the second controller 442 reduces the speed of the motor 412 in such a manner that a dehydration speed is reduced to a predetermined dehydration speed when a power rate encountered in the dehydration process is equal to or less than reference power rates.

In more detail, the second controller 442 controls the dehydration speed of the motor 412 at an energy rate that must be reduced by the washing machine prior to the rapid increasing of energy. For example, provided that the energy saving rate of 50% is a target energy saving rate and a set rpm generated in the dehydration process is set to 1300rpm, instantaneous power consumption is set to 600W, and instantaneous power consumption at 950rpm is set to 300W, the dehydration speed is changed from 1300rpm to 950rpm.

The second storage unit 443 stores power rates for each hour and reference power rates for each hour.

The second storage unit 443 stores power consumption of the motor 412 and power consumption of the heater 430, and stores the operation rate of the heater 430 and the operation rate of the motor 412 in response to the increasing rate of power rates.

In this case, the power consumption of the motor 412 or the heater 430 may be maximum instantaneous power or average power consumption.

The second input unit 444 receives a washing process command from a user or receives information regarding a reservation time for the washing process from the user, and transmits the received command and information to the second controller 442.

The second input unit 444 may also directly receive the operation rate of load (at least one of the heater and the motor) from the user. In this case, the second controller 442 may control the load operation on the basis of the operation rate of load entered by the user.

If necessary, the second input unit 444 may receive an acknowledgement (ACK) signal for operation rate adjustment.

The second display 445 displays power rates for each hour or power rate levels for each hour.

The second display 445 displays a state of the washing process. Here, if the progress state of the washing process and the operation rate of the washing process are adjusted, the second display 445 displays a message related to load (heater or motor) corresponding to the adjusted operation rate.

The second input unit 444 and the second display 445 are integrated into one body, and may be configured in the form of a touchscreen.

The second sound unit 446 audibly outputs information indicating whether power rates are changed.

If the operation rate of any load is adjusted, the second sound unit 446 audibly outputs a message to adjust the load operation rate upon receiving a message from the second controller 442.

The second sound unit 446 audibly outputs a message indicating the start of the washing process and a message indicating the end of the washing process.

The power metering unit 447 (also called a power monitoring unit) measures power consumption of the washing machine in real time, and transmits the measured power consumption to the second controller 442, such that it can detect the actual power consumption of the washing machine 400 and can update information regarding power consumption stored in the second storage unit 443.

The power metering unit 447 measures power using not only a voltage detected at both ends of the AC power line connected to a power connector (not shown) of the washing machine 400 but also a current detected by any one of AC power lines connected to the power connector.

The detection unit 448 includes a temperature detector to detect a temperature of wash water, and a water level detector to detect a water level of the rotary tub 411.

The load drive unit 449 includes a heater driver 449a to drive the heater 430 in response to a message of the second controller 442, and a motor driver 449b to drive the motor 412 in response to a message of the second controller 412.

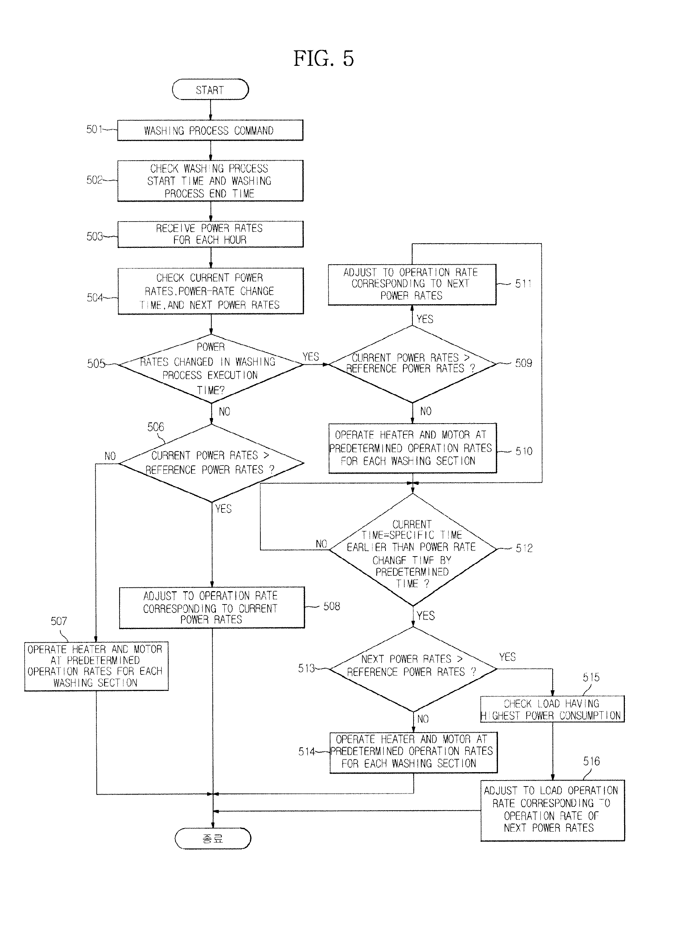

FIG. 5 is a flowchart illustrating a method of controlling a washing machine according to one embodiment.

Referring to FIG. 5, if the command for executing the washing process is entered by the user, a current time reaches a washing process reservation time, or the EMS 300 transmits the washing process execution command, the washing process start time and the washing process execution time are confirmed such that the washing process end time is confirmed at operation 502.

Thereafter, the washing machine receives the power rates for each hour from the EMS 300 at operation 503. In operation 504, the washing machine recognizes the current power rates, the next power rates, and a time caused by the next power rates on the basis of the received power rates for each hour. In addition, the washing machine further checks the maintenance time of the next power rates.

The washing machine determines whether the power-rate change time is within the washing process execution time in operation 505. If the power-rate change time is not within the washing process execution time in operation 505, the washing machine compares the current power rates with the reference power rates in operation 506 so that the washing machine determines whether the current power rates are higher than the reference power rates. If the current power rates are equal to or less than the reference power rates, the washing machine operates the motor 412 and the heater 430 at predetermined operation rates for individual washing sections in operation 507.

For example, the predetermined operation rates according to one embodiment are as follows. That is, in the case of the heating section of the washing or rinsing process, the operation rate of the heater 430 is set to 100% and the operation rate of the motor 412 is set to 100%. In the non-heating section of the washing or rinsing process, the operation rate of the heater 430 is set to 0%, and the operation rate of the motor 412 is set to 100%. In addition, the predetermined operation rate may be an operation rate at which the motor 412 is operated at a normal dehydration speed during the dehydration process. Such a predetermined operation rate may be changed in response to a process mode or a material of laundry to be dried.

On the other hand, if the current power rates are higher than the reference power rates, the washing machine determines the increasing rate of the current power rates on the basis of the reference power rates, and reduces the load operation rate in response to the determined increasing rate in operation 508.

In this case, the washing machine determines which load has the highest power consumption from among several loads operated in each washing section. In addition, the washing machine can search for data stored in the second storage unit 413 and then determine the searched data.

That is, load having the highest power consumption encountered in the heating section of the washing or rinsing process is the heater 430, and load having the height power consumption generated in the non-heating section of the washing or rinsing process is the motor 412. Therefore, the operation rate of the heater 430 is reduced during the heating section of the washing or rinsing process, and the operation rate of the motor 412 is reduced in the non-heating section of the washing or rinsing process.

In addition, the load of the highest power consumption generated in the dehydration process is set to the motor 412, so that the speed of motor 412 is reduced in the dehydration process and the dehydration speed is reduced to a specific speed corresponding to the power saving rate.

In this case, if the current power rates are higher than the reference power rates, this means that many homes are requesting much power from the power provider 100, such that there is a high possibility of increasing the number of power plants.

Therefore, when the current power rates are higher than the reference power rates, power consumption of the washing machine is reduced so that total of power requested in the power provider 100 by many homes can be reduced. As a result, environmental destruction caused by additional electricity generation of the power plants can also be reduced.

If the power-rate change time is within the washing process execution time, the washing machine compares the current power rates with the reference power rates, and compares the next power rates with the reference power rates in such a manner that the load operation rate can be adjusted.

In more detail, the washing machine compares the current power rates with the reference power rates in operation 509 so thatthe washing machine determines whether the current power rates are higher than the reference power rates. If the current power rates are equal to or less than the reference power rates, the motor 412 and the heater 430 are operated at the predetermined operation rates for individual washing sections in operation 510.

On the other hand, if the current power rates are higher than the reference power rates, the washing machine determines the increasing rate of the current power rates on the basis of the reference power rates, and reduces the load operation rate in response to the determined increasing rate in operation 511.

In this case, the washing machine recognizes which load has the highest power consumption from among several loads operated in respective washing sections, and reduces the recognized load operation rate.

Then, the washing machine determines whether a current time is located prior to a predetermined time (T) from the power-rate change time in operation 512.

If the current time is located prior to the predetermined time T from the power-rate change time, the washing machine compares the next power rates with the reference power rates in operation 513 so thatthe washing machine determines whether the next power rates are higher than the reference power rates.

In this case, if the next power rates are equal to or less than the reference power rates, the motor 412 and the heater 430 are operated at predetermined operation rates for each washing section in operation 514.

On the other hand, if the next power rates are higher than the reference power rates, the washing machine determines the washing section at a specific time that is located ahead of a predetermined time from the power-rate change time, and then confirms which load (i.e., the motor and the heater) has the highest power consumption within the determined washing section in operation 515.

The washing machine calculates the increasing rate of the next power rates on the basis of the next reference power rates, and reduces the load operation rate in response to the calculated power rate increasing rate in operation 516.

The washing machine confirms the maintenance time of the next power rates so thatthe washing machine determines the presence or absence of additional power rate variation. If additional power rate variation occurs before completion of the washing process, the washing machine performs operations 505 to 516.

The washing machine performs the washing process and at the same time periodically receives the future power rates and the future power rate change time from the EMS 300, and may also adjust the operation rates of several loads on the basis of the received future power rates and the received power rate change time.

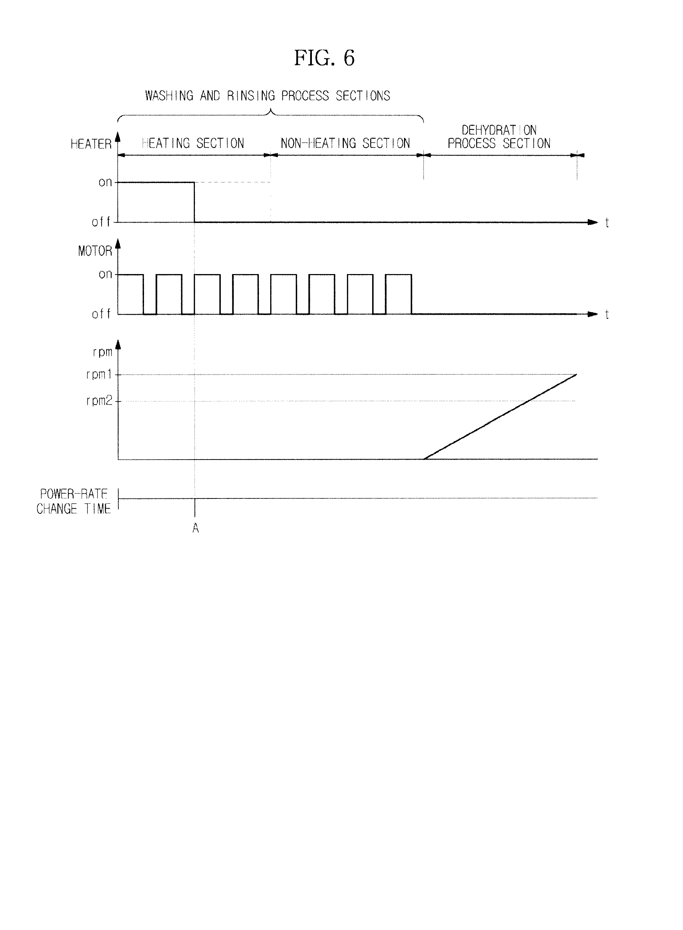

FIGS. 6 to 8 exemplarily illustrate a method of controlling a washing machine according to one embodiment.

Referring to FIG. 6, if the power rates are equal to or less than the reference power rates during the washing process of the washing machine, the motor 412 is operated at the operation rate of 100% and the heater 430 is operated at the operation rate of 100% during the heating section of the washing or rinsing process. In the non-heating section of the washing or rinsing process, the motor 412 is operated at the operation rate of 100% and the heater 430 is operated at the operation rate of 0%.

If the current power rates are higher than the reference power rates at a certain point of the heating section, the operation rate of the heater 430 having the highest power consumption in the heating section is reduced. For example, if the power saving rate is set to 50%, the operation rate of the heater 430 is reduced by 50% in response to the power saving rate of 50%.

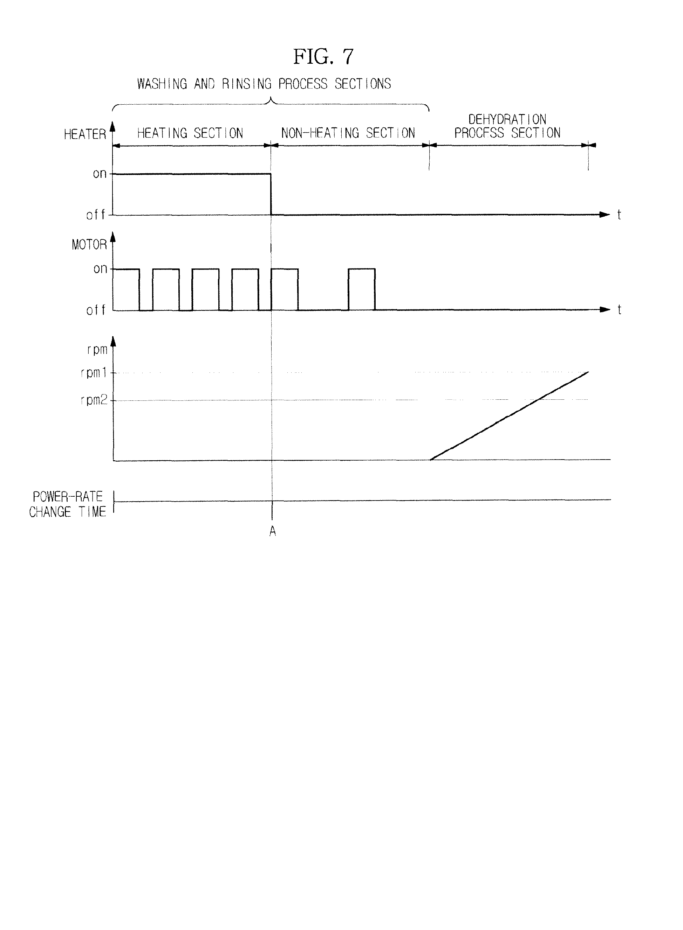

Referring to FIG. 7, if the current power rates are higher than the reference power rates at a certain point of the non-heating section, the operation rate of the motor 412 having the highest power consumption in the non-heating section is reduced. For example, if the power saving rate is set to 50%, the operation rate of the motor 412 is reduced by 50% in response to the power saving rate of 50%. In this case, the heater 412 stops operation.

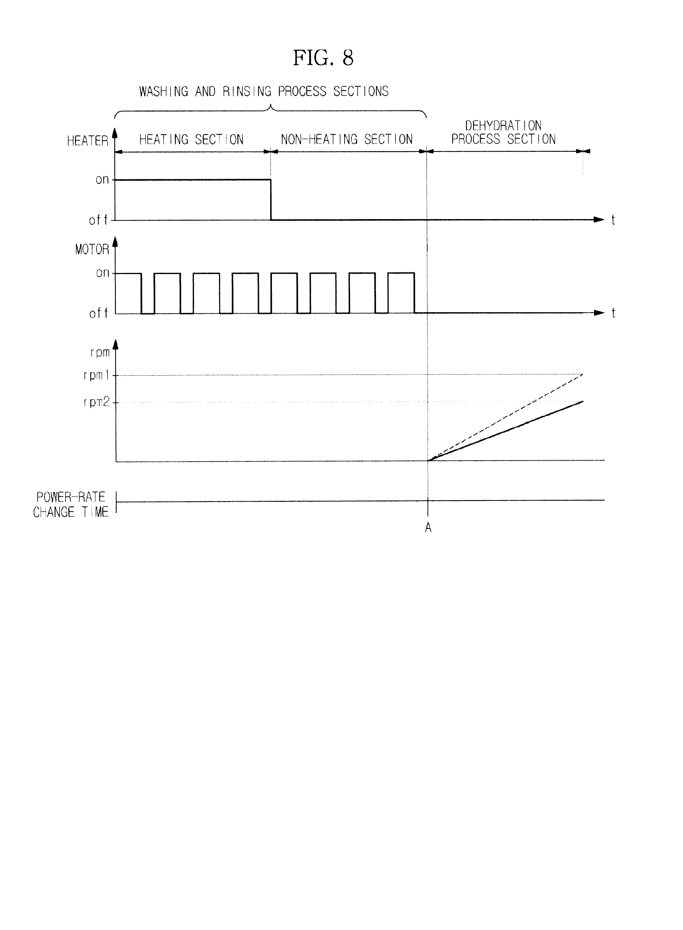

Referring to FIG. 8, if the current power rates are higher than the reference power rates at a certain point of the dehydration process, load having the highest power consumption encountered in the dehydration process is the motor 412, the dehydration speed is reduced as compared to a normal dehydration speed. For example, if the power saving rate is set to 50%, the speed of the motor 412 is controlled in such a manner that the dehydration speed is reduced to a specific dehydration speed (rpm2) corresponding to the power saving rate of 50% as compared to the normal dehydration speed (rpm1).

As described above, upon receiving power rate information for each hour from the EMS 300, the washing machine detects current power rates at power rate information for each hour, and compares the current power rates with reference power rates. If the current power rates are higher than the reference power rates, the washing machine reduces the operation rate of the highest power consumption load from among the motor and the heater at every process. The washing machine can change the load operation rate before the current power rates exceed the reference power rates, so thatthe washing machine prevents total power consumption from being rapidly increased and the power plant need not be additionally driven to generate more electricity.

However, based on an energy saving signal received from the EMS 300, the washing machine according to one embodiment determines which load has high power consumption at a process corresponding to a specific time at which the washing machine receives the energy saving signal, and reduces the operation rate of the determined load to a specific value corresponding to the energy saving signal. In this case, the energy saving signal commands the EMS 300 to receive information of a specific time point at which the rapid increasing of energy consumption is predicted, and also commands the washing machine to reduce energy consumption at the specific time at which the rapid increasing of energy consumption is predicted.

Operations of the washing machine according to another embodiment will hereinafter be described in detail.

Conventionally, priorities of household appliances operating in home are established. Thus, if current energy costs are high, operations of some household appliances stop operation are limited or halted, so that a user may have difficulty in using a desired product at a desired time.

Meanwhile, under the above-mentioned situation, provided that the washing machine is designed to replace a heater-based hot water providing function with external-input hot water, if the water heater corresponding to control priority due to high energy load is turned off, it may be difficult to implement a normal washing machine function, the control for obviating or reducing such difficulty is not applied to the washing machine, resulting in greater inconvenience of the user.

Therefore, the washing machine according to the embodiment provides a variable washing cycle by applying DR control to a water heater functionally related to a washing process, so thatthe washing machine can implement a user-desired laundry management level and can maximize the energy saving rate.

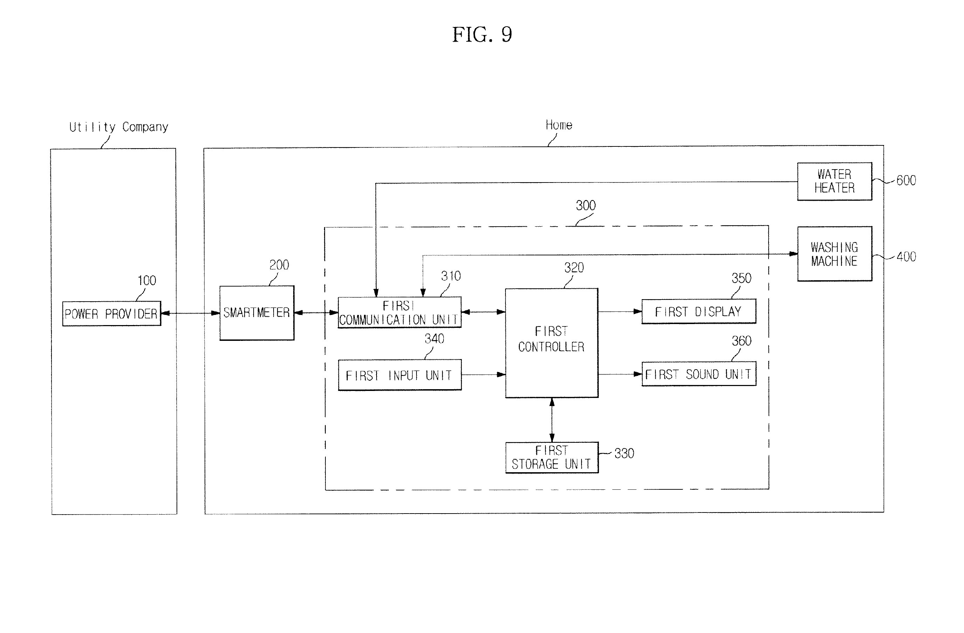

FIG. 9 is a block diagram illustrating a power management system to which a washing machine is applied according to an embodiment.

Referring to FIG. 9, the power management system includes a power provider 100, a smart meter 200, an EMS 300, a washing machine 400, and a water heater 600.

The water heater 600 provides hot water to the washing machine.

The washing machine shown in FIG. 9 according to another embodiment is identical to the washing machine shown in FIG.4 according to one embodiment, and as such a detailed description thereof will herein be omitted for convenience of description.

However, the EMS 300 receives status information such as operation information of a water heater in response to a request of the washing machine, and transmits the received status information of the water heater to the washing machine.

The washing machine 400 receives the water-heater status information from the EMS 300, and performs a substitute cycle on the basis of the received water-heater status information such that a washing cycle condition capable of being established by a user or a user desired washing level can be implemented in consideration of not only energy costs encountered in a section in which the washing machine is to be operated but also the operation or non-operation of the water heater.

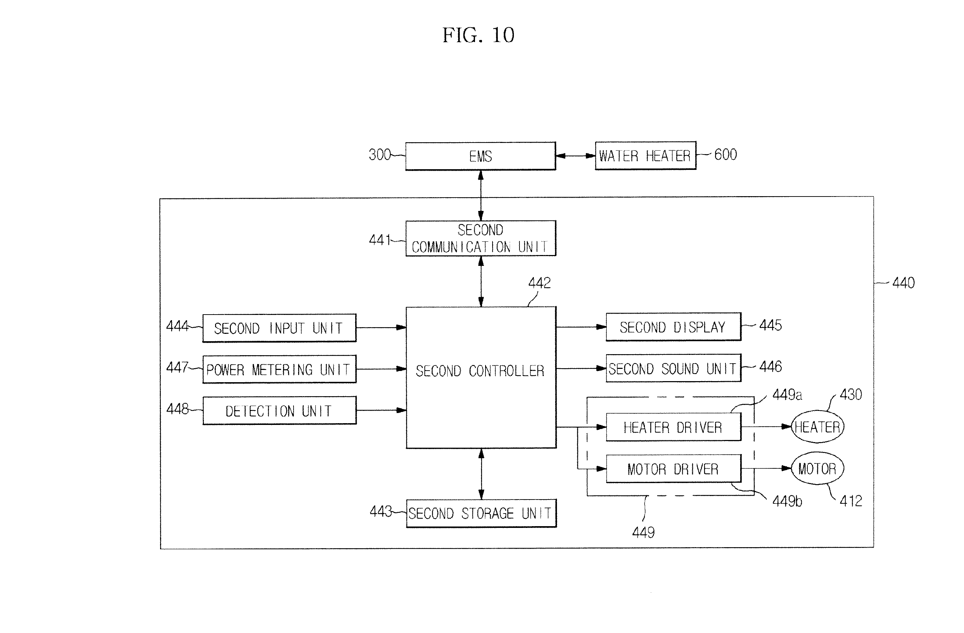

FIG. 10 is a flowchart illustrating a method of controlling a washing machine according to another embodiment.

Referring to FIG. 10, the control unit 440 for use in the washing machine 400 includes a second communication unit 441, a second controller 442, a second storage unit 443, a second input unit 444, a second display 445, a second sound unit 446, a power measurement unit 447, a detection unit 448, and a lower drive unit 449.

In the washing machine shown in FIG. 10 according to another embodiment, the second communication unit 441, the second controller 442, the second storage unit 443, the second input unit 444, the second display 445, the second sound unit 446, the power measurement unit 447, the detection unit 448, and the load drive unit 449 are identical to those of FIG. 4, and as such a detailed description thereof will herein be omitted for convenience of description.

The second controller 442 shown in FIG. 10 is identical to the second controller of FIG. 4, and as such a detailed description thereof will herein be omitted for convenience of description.

Upon receiving washing machine operation information from the user, the second controller 442 performs a substitute cycle on the basis of the received washing machine operation information such that a washing cycle condition capable of being established by a user or a user desired washing level can be implemented in consideration of not only energy costs encountered in a section in which the washing machine is to be operated but also the operation or non-operation of the water heater.

If the water heater 600 is turned off, the second controller 442 may delay the operation of the water heater 600 or limit a selectable washing cycle. If the water heater 600 is turned off, the second controller 442 may propose a substitute washing cycle so thatthe second controller 442 controls the washing cycle to be interoperable with the water heater 600.

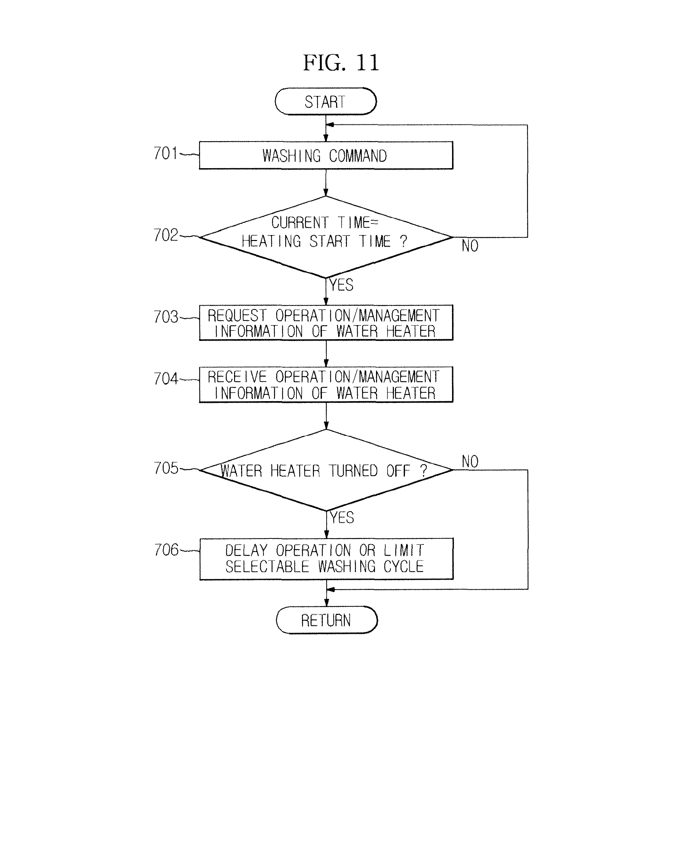

The method for delaying a washing cycle and limiting a selectable washing cycle under the condition that the water heater is turned off will hereinafter be described with reference to FIG. 11.

FIG. 11 is a flowchart illustrating a method for delaying a washing cycle or limiting a selectable washing cycle when a water heater of a washing machine is turned off according to another embodiment; and

Referring to FIG. 11, the control unit 440 for use in the washing machine 400 receives a washing command as an input in operation 701.

Upon receiving the washing command, the control unit 440 determines whether a current time is a heating start time of wash water in operation 702.

If a current time is a heating start time of wash water, the control unit 440 requests operation/management information of the water heater 600 from the EMS 300 in operation 703. The control unit 440 receives operation/management information of the water heater 600 from the EMS 300 in operation 704, and determines whether the water heater 600 is turned on or off by analyzing the operation/management information of the water heater 600 in operation 705.

If the water heater 600 is turned off, the control unit 440 may invite a user to delay the operation of the washing machine 400 until reaching a specific time at which the operation start of the water heater 600 is predicted, or such operation delay of the washing machine 400 may also be automatically established as necessary. Alternatively, the user-selectable washing temperature may be limited in consideration of a current cold water temperature so that a user-selectable washing cycle may be limited in operation 706.

For example, if the cold water temperature is equal to or higher than approximately 25°C degrees in summer, the washing temperature may be set up to approximately 30°C or a warm water temperature. If the cold water temperature is equal to or less than approximately 10°C in winter, the washing machine may be designed to select only a non-heating cold water washing function or a cold water washing function (i.e., a low-temperature washing function).

However, if the user desires to perform a high-temperature washing mode, a substitute cycle may be automatically provided. If capacity of the water heater 600 is less than that of the heater mounted to the washing machine 400, cold water is supplied to the washing machine, so that the washing machine 400 heats water alone so thatthe washing machine can be normally operated or controlled. In contrast, if energy consumption of the heater mounted to the washing machine is similar to that of a heating device of the water heater 600, the high-temperature washing cycle delays operation until energy costs are reduced to those of a normal state, and then starts to operate.

The method for proposing a substitute washing cycle when the water heater 600 is turned off will hereinafter be described in detail.

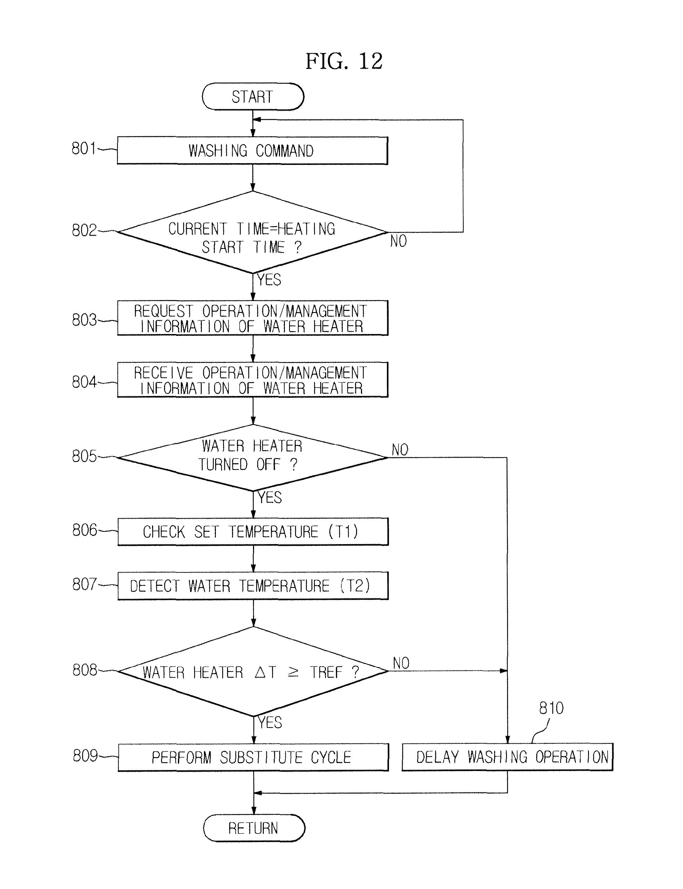

FIG. 12 is a flowchart illustrating a method for proposing a substitute washing cycle when the water heater 600 is turned off according to another embodiment.

Referring to FIG. 12, the control unit 440 for use in the washing machine 400 receives a washing command as an input in operation 801.

Upon receiving the washing command, the control unit 440 determines whether a current time is a heating start time of wash water in operation 802.

If a current time is a heating start time of wash water, the control unit 440 requests operation/management information of the water heater 600 from the EMS 300 in operation 803. The control unit 440 receives operation/management information of the water heater 600 from the EMS 300 in operation 804, and determines whether the water heater 600 is turned on or off by analyzing the operation/management information of the water heater 600 in operation 805.

If the water heater 600 is turned off, the control unit 440 confirms a set temperature T1 established by a user in operation 806, and detects a water temperature T2 in operation 807.

If a temperature difference T1-T2 is equal to or less than a predetermined temperature Tref in operation 808. If the temperature difference T1-T2 is equal to or less than the predetermined temperature Tref in operation 808, the control unit 440 performs a substitute cycle in operation 809.

Alternatively, if the temperature difference is higher than the predetermined temperature Tref in operation 809, the control unit 440 delays the washing process in operation 810.

For example, assuming that a current water temperature is approximately 20°C whereas a user desires to perform the washing process at a water temperature of approximately 40°C, the washing machine according to the embodiment provides a variable cycle, which increases the low-temperature washing effect, generates bubbles with low energy load and uses a washing motor for a longer time (i.e., increases a motor operation rate for each unit time or a washing time) in such a manner that the variable cycle can guarantee a desired washing power.

However, if the user desires to perform a sterilization function of approximately 90°C or higher and the heater mounted to the washing machine 400 has low capacity, cold water is supplied to the washing machine 400 in such a manner that the washing machine 400 may heat the cold water. In contrast, if energy consumption of the heater mounted to the washing machine 400 is similar to that of a heating device of the water heater 600, a high-temperature washing cycle delays operation to a specific time point at which energy costs are reduced to a normal state, and be then operated.

Hereinafter, a washing machine according to still another embodiment stores/analyzes information regarding energy variation encountered in a predetermined time, analyzes washing-machine use pattern information of a user during the predetermined time, and predicts/analyzes a user-requested throughput level needed for the washing machine. As a result, if a current time reaches a repetition duration, the washing-machine throughput level can be increased using the above-mentioned resultant data.

In recent times, as the importance of energy saving is rapidly increasing, it is necessary for the power provider to apply different energy costs to respective individual hours in response to energy demand situation. However, the conventional control method of the washing machine is unable to properly cope with such energy cost variation.

Therefore, DR devices, that receive information from the energy provider in real time and provide the received information to a corresponding household appliance, have been developed and come into the market, so that the legacy products need to be controlled in response to such technical environment. However, the current DR control applied to the products such as a washing machine is unable to maintain basic functions (washing performance, dehydration and drying performances) that must be provided to a consumer, is designed to reduce energy costs by reducing only energy load. As a result, if energy costs are high, the conventional DR control has been generally designed only to delay the washing machine operation.

Meanwhile, the reason why the energy supply company establishes energy costs to individual hours is as follows. If a user desires to use the household appliance consuming electricity for a long time, the energy demand is increased. Generally, the electrical capacity increasing of the household appliance is affected by environmental and weather situations, etc.

For example, most consumers prefer to use air-conditioners in summer, so that electricity demand is abruptly increased. In contrast, most users use the heating function and hot water in winter, so that electricity demand is also increased. In this way, the electricity demand is greatly affected by environment variation and seasonal reasons.

The washing machine according to still another embodiment stores/analyzes information regarding energy variation encountered in a predetermined time, analyzes washing-machine use pattern information of a user during the predetermined time, and predicts/analyzes a user-requested throughput level needed for the washing machine. As a result, if a current time reaches a repetition duration, the embodiment provides a smart cycle that is insensitive to energy variation encountered in the repetition duration and implements a washing-machine performance level frequently requested by the user on the basis of the above-mentioned data. As a result, the embodiment does not delay the process execution of the washing or drying machine, enables the washing machine to perform a desired process in the same manner as in the conventional method, resulting in greater convenience of the user.

When providing the smart cycle, assuming that a variety of items related to variation of the washing machine process can be detected (for example, the type of laundry put into the washing machine, water characteristics, pollution degree, a detergent type, external environment characteristics), the smart cycle depending upon not only washing-machine use pattern information of the user but also the energy environment variation may variably control any additional cycle based on the sensed information.

The washing machine stores/analyzes energy variation affecting the washing machine cycle variation through internal/external storage units thereof during either a user-selected period or another period automatically established by the washing machine, and stores/analyzes washing-machine use pattern information of the user (e.g., selected program, selected options (washing temperature, dehydration degree, pollution degree, soaked washing, preliminary washing)) through internal/external storage units thereof.

If a current time repeatedly reaches the above-mentioned predetermined period after the user has continuously used the manufactured product, the washing machine according to the embodiment provides an optimum smart cycle that is insensitive to energy variation expected in the predetermined time so thatthe washing machine does not increase energy costs. In addition, the smart cycle can satisfy a washing machine performance level frequently requested by the user.

In this case, the washing machine may provide the analyzed energy situation and the user's product use pattern information to the user. If necessary, the analyzed energy situation and the product use pattern information may also be provided through a separate external device.

Provided that the user decides to use the above smart cycle or the washing machine is designed to automatically accept the smart cycle, or provided that the washing machine is initially established to operate the smart cycle, the washing machine of the embodiment performs the smart cycle.

On the other hand, according to another smart cycle according to the embodiment, if not only the analyzed information but also temporary variation information (for example, the type of laundry put into the washing machine, water characteristics, pollution degree, a detergent type, peripheral environmental characteristics (temperature or humidity) related to the washing machine driver operation) is received or detected in the washing machine, the detected result is reflected in the smart cycle, so that the smart cycle is variably applied to the washing machine according to the user's product use pattern information and the energy variation.

By the above-mentioned processes, the washing machine according to the embodiment can be used in the same manner as in the conventional washing machine without delaying the function execution when a current state requires high energy costs, and at the same time can prevent the rapid increasing of energy costs, resulting in greater convenience of the user.

Although the above-mentioned embodiments are limited to the washing machine and a method of controlling the same, the scope or spirit of the embodiments are not limited thereto, and can also be applied to other household appliances, for example, air-conditioners, refrigerators, kimchi refrigerators, cooking devices, robot cleaners, TVs. That is, the embodiments may be applied to any of household appliances having a plurality of loads differently used according to operation cycles, and the operation rate of each household appliance may be variably determined in response to the operation cycles.

For example, the air-conditioner uses a compressor and a fan as basic loads, detects current power rates from among power rate information for each hour received from the EMS, and compares current power rates with reference power rates. If the current power rates are higher than the reference power rates, the embodiment may allow the air-conditioner to reduce the operation rate of the compressor or the fan.

As is apparent from the above description, the washing machine capable of performing a heating washing function according to embodiments receives state information of a water heater that supplies hot water to the washing machine, and determines whether the water heater is turned off in response to the received water heater state information. If the water heater is turned off, the operation start of the washing machine is delayed until reaching a specific time at which the water heater starts operation, user-selectable water temperature adjustment may be limited on the basis of a current cold water temperature. In addition, instead of reducing the water temperature, the washing machine according to the embodiment may increases the operation rate of the motor or increase the washing time.

In accordance with one aspect, the washing machine according to the embodiment changes the load operation rate before power rates exceed reference power rates, resulting in reduction in power consumption. Further, as the washing machine can prevent total power consumption from being rapidly increased, the power plant need not be additionally driven to generate more electricity. As a result, the washing machine reduces environmental impact and prevents power rates from being further increased.

In addition, the washing machine can adjust the load operation rate in response to the determined rate, thereby preventing the washing function from being deteriorated.

The washing machine can control the washing cycle, such that the total power consumption for each home is reduced and power consumption is prevented from exceeding allowable power consumption.

The operating method of the processor according to the above-described embodiments may be recorded in non-transitory computer-readable media including program instructions to implement various operations embodied by a computer. The media may also include, alone or in combination with the program instructions, data files, data structures, and the like. Examples of non-transitory computer-readable media include magnetic media such as hard disks, floppy disks, and magnetic tape; optical media such as CD ROM disks and DVDs; magneto-optical media such as optical disks; and hardware devices that are specially configured to store and perform program instructions, such as read-only memory (ROM), random access memory (RAM), flash memory, and the like. Examples of program instructions include both machine code, such as produced by a compiler, and files containing higher level code that may be executed by the computer using an interpreter. The described hardware devices may be configured to act as one or more software modules in order to perform the operations of the above-described embodiments, or vice versa. Any one or more of the software modules described herein may be executed by a dedicated processor unique to that unit or by a processor common to one or more of the modules. The described methods may be executed on a general purpose computer or processor or may be executed on a particular machine such as the processor supporting a method for controlling a washing machine described herein.

Although a few embodiments have been shown and described, it would be appreciated by those skilled in the art that changes may be made in these embodiments without departing from the principles and spirit of the invention, the scope of which is defined in the claims and their equivalents.

## Claims

1. A washing machine comprising:
a motor to rotate a rotary tub including laundry;
a heater to heat water contained in the rotary tub;
a communication unit to receive power rate information for each hour from an energy management system (EMS); and
a controller to recognize current power rates from among the received power rate information for each hour, determine if the current power rates exceed a reference power rates by comparing the current power rates with the reference power rates, and reduce an operation rate of any one of the motor and heater if the current power rates exceed the reference power rates.

2. The washing machine according to claim 1, further comprising:
a storage unit to store power consumption of the motor and power consumption of the heater,
wherein the controller recognizes a current washing section from among several washing sections, recognizes one load having highest power consumption from among several loads operated in the current washing section, and reduces an operation rate of the recognized load.

3. The washing machine according to claim 1, further comprising:
a storage unit to store an operation rate corresponding to power rates,
wherein the controller recognizes a current washing section from among several washing sections, recognizes one load having highest power consumption from among several loads operated in the current washing section, and reduces an operation rate of the recognize load to a specific operation rate corresponding to the current power rates.

4. The washing machine according to claim 1, wherein the controller divides each of a washing process and a rinsing process from among the washing sections into a heating section and a non-heating section, determines which load has highest power consumption from among several loads operated in each divided section, and controls the determined load to be operated at an operation rate corresponding to the current power rates.

5. The washing machine according to claim 1, further comprising:
a storage unit to store a dehydration speed corresponding to power rates,
wherein the controller reduces a dehydration speed of a dehydration process section from among the washing sections to a specific dehydration speed corresponding to the current power rates.

6. The washing machine according to claim 1, wherein the controller determines whether power rates are changed in the washing and rinsing processes on the basis of the power rate information for each hour, recognizes the next power rates when the power rates are changed in the washing and rinsing processes, determines whether the next power rates are higher than the reference power rates by comparing the next power rates with the reference power rates, and reduces the operation rate of either the motor or the heater from a power-rate change time when the next power rates are higher than the reference power rates.

7. The washing machine according to claim 6, wherein the controller adjusts the operation rate of either the motor or the heater from a specific time earlier than the power-rate change time by a predetermined time.

8. The washing machine according to claim 1, wherein the controller determines whether power rates are changed in a dehydration process on the basis of the power rate information for each hour, recognizes the next power rates when the power rates are changed in the dehydration process, determines whether the next power rates are higher than the reference power rates by comparing the next power rates with the reference power rates, and reduces the operation rate of either the motor or the heater from a power-rate change time when the next power rates are higher than the reference power rates.

9. The washing machine according to claim 1, further comprising:
the input unit to receive a power saving rate from a user,
wherein the controller adjusts the operation rate of either the motor or the heater in response to the power saving rate.

10. The washing machine according to claim 1, further comprising:
a storage unit to store load operation rates for each process at a point less than the reference power rates,
wherein the controller controls the operation rates of the motor and the heater on the basis of the operation rate stored in the storage unit when the current power rates are less than the reference power rates.

11. A method of controlling a washing machine that includes a motor to rotate a rotary tub including laundry and at least one heater to heat water contained in the rotary tub, the method comprising:
receiving power rate information for each hour from an energy management system (EMS);
recognizing current power rates on the basis of the power rate information for each hour;
determining whether the current power rates are higher than reference power rates by comparing the current power rates with the reference power rates; and
reducing an operation rate of any one of the motor and the at least one heater when the current power rates are higher than the reference power rates.

12. The method according to claim 11, wherein the reducing of the operation rate of any one of the motor and the at least one heater includes:
recognizing a washing section;
recognizing a load to be operated in the recognized washing section;
recognizing each load having highest power consumption from among several loads to be operated in the recognized washing section; and
reducing the operation rate of each load having the highest power consumption in the recognized washing section.

13. The method according to claim 12, wherein the reducing of the operation rate of any one of the motor and the at least one heater includes:
reducing the operation rate of each load having the highest power consumption to an operation rate corresponding to the current power rates.

14. The method according to claim 11, further comprising:
controlling operation rates of the motor and the at least one heater on the basis of a predetermined operation rate when the current power rates are equal to or less than the reference power rates.

15. The method according to claim 14, further comprising:
recognizing an execution time of the washing process;
determining whether power rates are changed in the washing process execution time on the basis of power rate information for each hour;
if the power rates are changed in the washing process execution time, recognizing the next power rates and a power-rate change time; and
comparing the next power rates with reference power rates to determine whether the next power rates are higher than the reference power rates, and reducing an operation rate of the motor and at least one heater from the power-rate change time when the next power rates are higher than the reference power rates.
